# EUROPEAN PATENT SPECIFICATION

(11) **EP 1 218 289 B1**
(45) Date of publication and mention of the grant of the patent: **09.03.2011**
(21) Application number: 99969587.7
(22) Date of filing: 28.09.1999
(51) Int. Cl.: B81C 1/00, H01L 21/18

(54) **DISSOLVED WAFER FABRICATION PROCESS AND ASSOCIATED MICROELECTROMECHANICAL DEVICE HAVING A SUPPORT SUBSTRATE WITH SPACING MESAS**
HERSTELLUNGSVERFAHREN MIT AUFLÖSUNG DER HALBLEITERSCHEIBE UND ENTSPRECHENDE MIKROELEKTROMECHANISCHE VORRICHTUNG AUF EINEM TRÄGERSUBSTRAT MIT DISTANZMESAS
PROCEDE DE FABRICATION DE PLAQUETTE DISSOUT ET DISPOSITIF MICRO-ELECTROMECANIQUE ASSOCIE A SUBSTRAT DE SUPPORT COMPOSE DE MESAS D'ECARTEMENT

(43) Date of publication of application: 03.07.2002
(73) Proprietor: HONEYWELL INC., Minneapolis, MN 55408 (US)
(72) Inventor: MAXWELL, Ken, Hays, Santa Ana, CA 92705-2120 (US)
(74) Representative: Buckley, Guy Julian
(86) International application number: PCT/US1999/022467
(87) International publication number: WO 2001/023300

(56) References cited:
- EP-A- 0 820 104
- US-A- 5 273 939
- US-A- 5 578 843
- US-A- 5 650 568
- SCHRODER: "SEMICONDUCTOR MATERIAL AND DEVICE CHARACTERIZATION" WILEY , USA , pages 203-207

## Description

### FIELD OF THE INVENTION

The present invention relates to a microelectromechanical device and method for making the device. In particular, the invention relates to a microelectromechanical device having a support substrate that includes mesas for supporting the doped region of a partially sacrificial substrate which defines various mechanical and/or electro-mechanical members of the microelectromechanical device and a method for making the device.

### BACKGROUND OF THE INVENTION

Traditionally, the miniaturization of mechanical and/or electromechanical systems has been frustrated by limitations on the manufacture of small lightweight mechanical or electromechanical parts. The intricacy of the parts made their manufacture on a small scale difficult and impractical. For instance, until recently, heavy and large gimbal systems were used for navigational guidance systems in the aerospace industry. These systems contained mechanical parts that were formed of metal and were generally large and heavy. However, the intricacy of the mechanical parts made miniaturization of the navigational guidance system difficult.

However, in recent years with the proliferation and increased precision in semiconductor fabrication procedures, many of the mechanical and electromechanical structures in a mechanical system may now be replaced by microelectromechanical structures (MEMS) that are fabricated by semiconductor fabrication techniques. For instance, some gimbal systems have been replaced by gyroscopes that include one or more MEMS devices. An example of these gyroscopes is described in U.S. Patent No. 5,650,568 to Greiff et al.

The Greiff et al. '568 patent describes a gimballed vibrating wheel gyroscope for detecting rotational rates in inertial space. The typical gimbals of the traditional larger and heavier mechanical systems have been replaced by the lightweight, miniaturized MEMS devices. These MEMS devices that form the various mechanical and/or electromechanical parts of the gyroscope are fabricated with conventional semiconductor techniques. The electrical properties of the gyroscope are then used to provide power to these parts and to receive signals from the parts.

An important advantage in the use of MEMS devices for mechanical and electromechanical systems is the reduction of size and weight that can be achieved over the conventional mechanical systems that use metal parts. However, many mechanical and electromechanical systems, such as the gimballed systems described above, have many moving parts that must be accurately fabricated in order to operate properly with the requisite accuracy and precision. Thus, the ability to replace metallic parts with MEMS devices fabricated by semiconductor techniques is limited by the precision that can be achieved with the semiconductor fabrication techniques. Although current semiconductor fabrication techniques have been utilized to manufacture MEMS devices, these fabrication procedures still present several limitations as described below in conjunction with the Greiff et al. '568 patent.

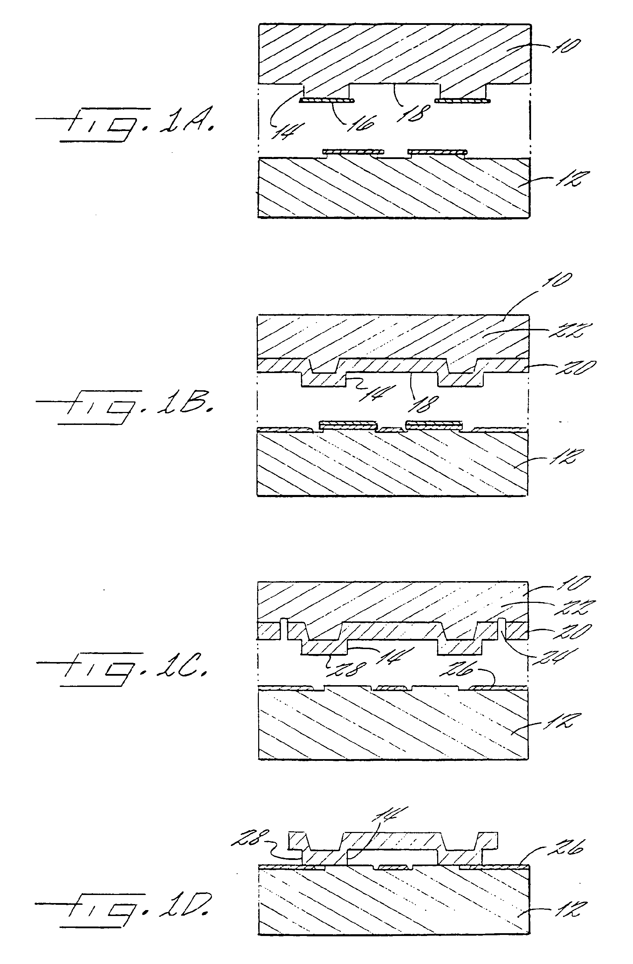

In this regard, Figures 1A-1D illustrate a conventional method for manufacturing MEMS devices with conventional semiconductor fabrication techniques. The process illustrated in these figures is commonly known as a Dissolved Wafer Process (DWP) and is described in the Greiff et al. '568 patent.

In particular, with reference to Figure 1A, a silicon substrate **10** and a support substrate **12** are shown. In a typical MEMS device, the silicon substrate is etched to form the mechanical and/or electromechanical members of the device. The mechanical and/or electromechanical members are generally supported above the support substrate such that the mechanical and/or electromechanical members have freedom of movement. This support substrate is typically made of an insulating material, such as Pyrex glass.

As illustrated in Figure 1A, support members **14** are initially etched from the inner surface of the silicon substrate. These support members are commonly known as mesas and are formed by etching, such as with potassium hydroxide (KOH), those portions of the inner surface of the silicon substrate that are exposed through an appropriately patterned layer of photoresist **16**. Preferably, the etching is continued until mesas **14** of a sufficient height have been formed.

With reference to Figure 1B, the etched inner surface **18** of the silicon substrate is thereafter doped, such as with boron, to provide a doped region **20** of a predetermined depth such that the silicon substrate **10** has both a doped region **20** and an undoped sacrificial region **22**. Referring to Figure 1 C, trenches are then formed, such as by a reactive ion etching (RIE), that extend through the doped region **20** of the silicon substrate **10**. These trenches form the mechanical and/or electromechanical members of the MEMS device.

As shown in Figures 1A-1C, the support substrate **12** is also initially etched and metal electrodes **26** and conductive traces (not shown), are formed on the inner surface of the support substrate. These electrodes and conductive traces will subsequently provide electrical connections to the various mechanical and/or electromechanical members of the MEMS device.

Once the support substrate **12** is processed to form the electrodes and conductive traces, the silicon substrate 10 and the support substrate **12** are bonded together. With reference to Figure 1D, the silicon and support substrates are bonded together at contact surfaces **28** on the mesas **14**, such as by an anodic bond. As a final step, the undoped sacrificial region **22** of the silicon substrate is etched away such that only the doped region that comprises the mechanical and/or electromechanical member of the resulting MEMS device remains. The mesas that extend outwardly from the silicon substrate therefore support the mechanical and/or electromechanical members above the support substrate such that the members have freedom of movement. Further, the electrodes formed by the support substrate provide an electrical connection to the mechanical and/or electromechanical members through the contact of the mesas with the electrodes.

As known to those skilled in the art, the step of reactive ion etching trenches through the doped region **20** of the silicon substrate **10** must be controlled to insure that the resulting trenches are accurately located on the inner surface of the partially sacrificial substrate and that the widths and walls of the trenches are formed with great precision. For example, the trenches formed by RIE must generally be formed to within a tolerance of 0.1 to 0.2 microns of a predetermined width. Further, it is important that the trenches extend completely through the doped region. As such, the inner surface of the silicon substrate must be planar and the doped region must have a predetermined thickness. While the silicon substrate **10** can be initially formed to have a planar inner surface, the inner surface of the silicon substrate is thereafter etched to form the mesas **14**. Unfortunately, an etching process will produce a surface that is no longer planar, but which, instead, has a number of surface irregularities. Accordingly, because the surface is non-planar, the subsequent RIE step cannot produce trenches that are accurately located on the inner surface doped region of the partially sacrificial substrate nor can the walls of the trenches be etched with great precision. Further, the subsequent RIE step may not produce trenches that extend completely through the doped region or may produce trenches that extend too far into the undoped sacrificial region of the silicon substrate.

Thus, a method is needed for manufacturing MEMS devices utilizing semiconductor fabrication techniques that separate the various mechanical and/or electromechanical members by means of RIE through the planar inner surface of a silicon substrate such that the trenches formed by RIE extend completely through the doped region of the sacrificial silicon substrate and are precisely located on the inner surface of the doped region of the silicon substrate and have precisely defined walls.

Further, a method is needed for manufacturing a gimballed vibrating wheel gyroscope for detecting rotational rates in inertial space, where the mechanical and/or electromechanical parts of the gyroscope are manufactured with increased precision.

### SUMMARY OF THE INVENTION

According to the present invention there is provided a method for forming a micro-electromechanical structure, wherein said method comprises the steps of:
providing a partially sacrificial substrate having a first surface;
doping a portion of said partially sacrificial substrate with a dopant such that said partially sacrificial substrate includes a doped region and an undoped region, wherein the doped region is adjacent the first surface of said partially sacrificial substrate;
providing a support substrate for supporting said partially sacrificial substrate, wherein said support substrate is a dielectric material;
forming at least one mesa on a respective surface of said support substrate such that said at least one mesa extends outwardly from the respective surface and has a contact surface extending between a set of sloped side walls;
depositing a conductive material on at least a portion of the contact surface and at least one of the sloped sidewalls of said at least one mesa to form an electrode; and
bonding said first surface of said partially sacrificial substrate to said at least one mesa such that the first surface of said partially sacrificial substrate is suspended above the remainder of the respective surface of said support substrate with the doped region of said partially sacrificial substrate in a facing relationship thereto.

As set forth below, the method for forming a MEMS device and the associated MEMS device of the present invention overcome the deficiencies identified with conventional methods. In particular, the method of the present invention may separate the various mechanical and/or electromechanical members of the MEMS device by etching, such as by RIE, through the inner surface of a partially sacrificial substrate that is planar such that the resulting trenches are precisely defined in terms of dimension, position and depth. In particular, for a MEMS device constructed primarily from the doped region of a partially sacrificial substrate and a support substrate, the method of the present invention forms the support mesas from the support substrate instead of the partially sacrificial substrate. By forming the mesas from the support substrate rather than the inner surface of the partially sacrificial substrate, the inner surface of the partially sacrificial substrate remains planar for etching procedures that separate the precise mechanical and/or electromechanical members. As such, MEMS devices having mechanical and/or electromechanical members can be reliably produced.

Further, the present invention provides a micro-electromechanical device comprising:
a doped region of a partially sacrificial substrate defining at least one member of the microelectromechanical device; and
a support substrate for supporting said doped region, wherein said support substrate is a dielectric material and includes at least one mesa extending outwardly from a respective surface of said support substrate, wherein said mesa includes a contact surface that supports said doped region;
such that said doped region is suspended above a remainder of the respective surface of said support substrate;
wherein said contact surface of said mesa extends between a set of sloped sidewalls; characterized by
an electrode, in electrical communication with said doped region extends across a portion of said contact surface and at least one of said sloped sidewalls of said mesa.

Because the mesas are formed from the support substrate as opposed to the partially sacrificial substrate, the inner surface of the partially sacrificial substrate remains planar for later etching to separate the mechanical and/or electromechanical members.

These and other advantages are provided, according to the present invention, by a method for forming a MEMS device that initially provides a partially sacrificial substrate having a planar inner surface. The partially sacrificial substrate is doped such that the partially sacrificial substrate includes both a doped region and an undoped sacrificial region, wherein the doped region is adjacent to the inner surface of the partially sacrificial substrate. The method of the present invention also provides a support substrate, formed of a dielectric material, for supporting the partially sacrificial substrate. To suspend the partially sacrificial substrate above the support substrate the method of the present invention includes the step of forming at least one mesa on the support substrate, such that the mesa extends outwardly from the remainder of the inner surface of the support substrate.

The method of the present invention further includes the step of bonding the inner surface of the partially sacrificial substrate to the mesa such that the partially sacrificial substrate is suspended above the remainder of the support substrate and the doped region of the partially sacrificial substrate is in a facing relationship with the support substrate. By forming the mesas on the support substrates, the inner surface of the partially sacrificial substrate remains planar to facilitate forming the mechanical and/or electromechanical members of the MEMS device.

The method of the present invention preferably further includes the step of dissolving or otherwise removing the undoped sacrificial region of the partially sacrificial substrate after the partially sacrificial substrate has been bonded to the mesas of the support substrate. By removing the undoped region of the partially sacrificial substrate, the mechanical and/or electromechanical members formed from the doped region of the partially sacrificial substrate have freedom to move. Further, the removal of the undoped sacrificial region of the partially sacrificial substrate reduces the retention of heat by the resulting MEMS device.

Another important aspect of the present invention is the establishment of appropriate electrical connections with the mechanical and/or electromechanical members of the MEMS device. To facilitate these connections, the method of the present invention includes the step of depositing a conductive material on at least a portion of the surface of the mesa to thereby form an electrode that is in electrical communication with the doped region of the partially sacrificial substrate once the partially sacrificial substrate and the support substrate have been bonded. The electrodes can then establish an electrical connection with the mechanical and/or electromechanical members of the MEMS device.

The method of the present invention includes the step of forming at least one mesa that has a contact surface extending between a set of sloped sidewalls. As such, the conductive material can be deposited on at least a portion of the contact surface and at least one sloped sidewall of the mesa. Because the sidewalls of the mesa are sloped, the metallic material can be more readily deposited on the mesa.

In a further embodiment of the method of the present invention, the mesa having sloped sidewalls is formed by applying a photoresist layer on the surface of the support substrate at locations corresponding to the predetermined locations of the mesas. The photoresist layer is preferably dimensionally sized to approximate the dimensions of the respective bases of the mesas. The method of this embodiment further includes the step of etching the exposed surface of the support substrate while simultaneously gradually reducing the dimensional size of the photoresist layer such that the resulting mesa has a contact surface extending between a set of sloped sidewalls. Since the photoresist layer shrinks during the etching process, the contact surface of each mesa is smaller than the corresponding base.

The present invention also provides a MEMS device having precisely defined mechanical and/or electromechanical members. The MEMS device of this embodiment includes a semiconductive substrate that has an inner surface. The MEMS device of the present invention further includes a support substrate, typically formed of dielectric material, having at least one outwardly extending mesa for supporting the semiconductive substrate. Each mesa includes a contact surface that supports the semiconductive substrate such that the semiconductive substrate is suspended above the remainder of the support substrate. Because the mesas extend outwardly from the support substrate and are thus, not etched from on the semiconductive substrate, the MEMS device can include mechanical and/or electromechanical members that are precisely defined.

The mesas of the MEMS device includes a contact surface that extends between two sloped sidewalls. In addition, the MEMS device includes an electrode that is formed on both a portion of the contact surface and at least one sloped sidewall of the mesa since the sloped sidewalls allow the metallic material which forms the electrodes and traces to be more easily deposited.

Accordingly, the fabrication method and associated MEMS device of the present invention provide mesas that are formed from the support substrate. By forming the mesas from the support substrate, the inner surface of the partially sacrificial substrate remains planar such that the mechanical and/or electromechanical members of the resulting MEMS device may be formed from the partially sacrificial substrate with greater precision and reliability.

### BRIEF DESCRIPTION OF THE DRAWINGS

Figures I1A-1D are sequential cross-sectional views of a conventional method for forming a MEMS device.
Figures 2A-2F are sequential cross-sectional views illustrating the operations performed to form a MEMS device according to one embodiment of the present invention.
Figure 3 is a block diagram of the operations performed to manufacture a MEMS device according to one embodiment of the present invention.
Figure 4 is a block diagram of the operations performed to form mesas on a support substrate according to one embodiment of the present invention.
Figure 5 is a block diagram of the operations performed to form electrodes on the support substrate according to one embodiment of the present invention.
Figure 6 is a block diagram of the operations performed to form mechanical and/or electromechanical members of a MEMS device from the doped region of a partially sacrificial substrate according to one embodiment of the present invention.
Figure 7 is a block diagram of the operations performed to form mesas having sloped sidewalls on the support substrate according to one embodiment of the present invention.
Figure 8 is a plan view of a vibrating wheel gyroscope according to one embodiment of the present invention.
Figures 9-14 are cross-sectional views of the gyroscope of Figure 8 at various stages of fabrication in accordance with one embodiment of the invention.
Figure 15 is a partial cross-sectional view of the gyroscope of Figure 8.

### DETAILED DESCRIPTION OF THE PREFERRED EMBODIMENT

The present invention will now be described more fully hereinafter with reference to the accompanying drawings, in which a preferred embodiment of the invention is shown. This invention may, however, be embodied in many different forms and should not be construed as limited to the embodiments set forth therein; rather, this embodiment is provided so that this disclosure will be thorough and complete and will fully convey the scope of the invention to those skilled in the art. Like numbers refer to like elements throughout.

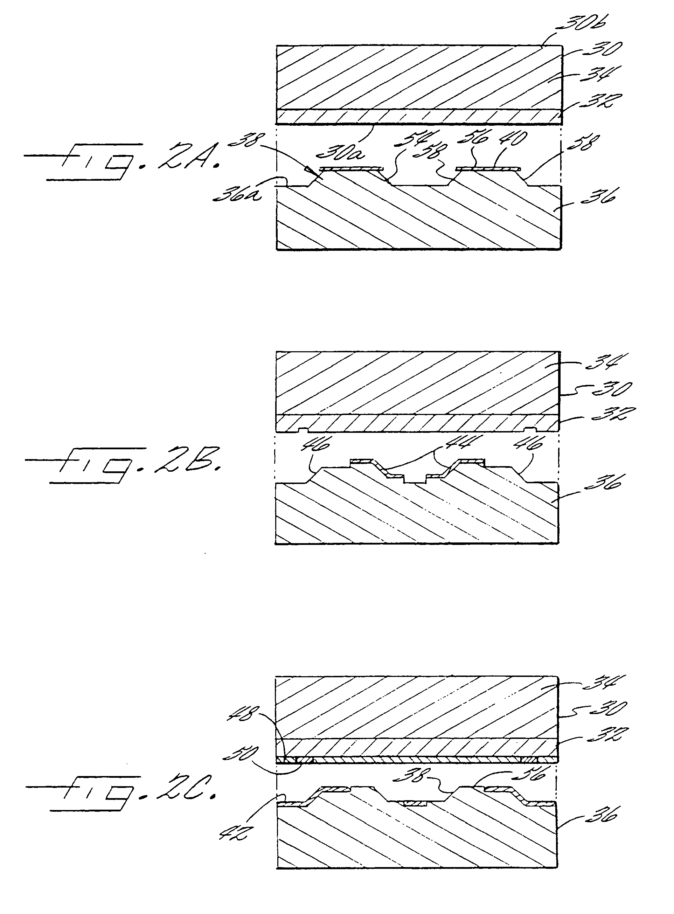

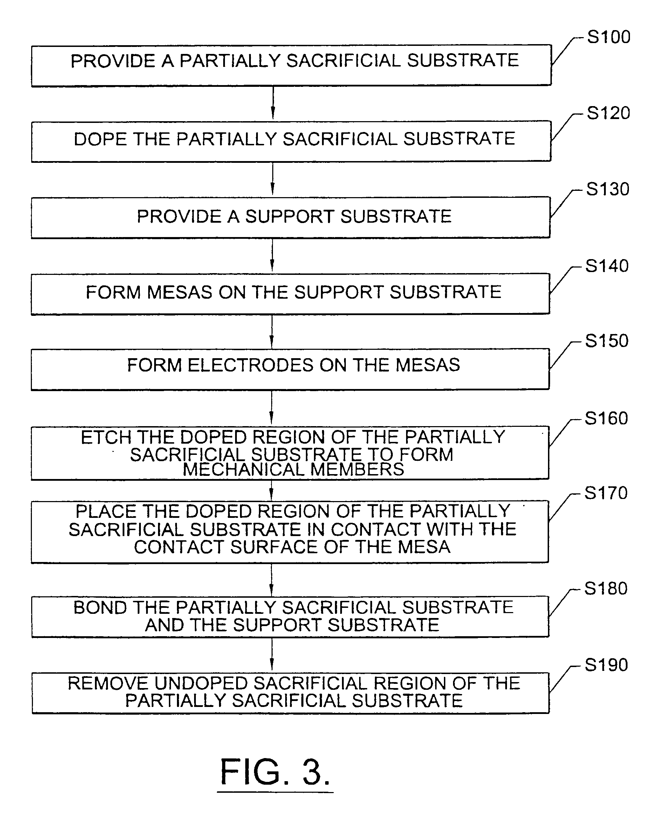

The method of the present invention fabricates unique MEMS devices having precisely defined mechanical and/or electromechanical members by maintaining the planar nature of the inner surface of the partially sacrificial substrate such that the mechanical and/or electromechanical members can be separated or otherwise formed in a precise and reliable fashion. Figures 2A-2F illustrate an advantageous embodiment of the method and device of the operations performed to fabricate MEMS devices according to the present invention. With reference to Figures 2A-2F and the block diagram of Figure 3, the fabrication method of the present invention includes the step of providing a partially sacrificial substrate 30 having inner and outer surfaces 30a, 30b. (See step S100). In the preferred embodiment, the partially sacrificial substrate is silicon, however, this partially sacrificial substrate can be of any particular material that can be doped to form a doped region such as a gallium arsenide, germanium, etc.

The method of the present invention further comprises the step of doping (step S120) a portion of the partially sacrificial substrate such that the partially sacrificial substrate includes both a doped region 32, adjacent the inner surface 30a, and an undoped sacrificial region 34, adjacent the outer surface 30b. The partially sacrificial substrate is doped with a dopant to a predetermined depth relative to the inner surface, such as 10 microns.

In a preferred embodiment, the dopant is introduced into the partially sacrificial substrate by a diffusion method as commonly known in the art. However, the method of the present invention is not limited to this technique and thus, the doped region adjacent to the inner surface of the partially sacrificial substrate may be formed by any method known in the art. Further, in the illustrative embodiment, the partially sacrificial substrate is doped with a boron dopant, however, the dopant may consist of any type dopant that forms a doped region within the partially sacrificial substrate.

With reference to Figures 2A and 3, the method of the present invention also includes the step of providing a support substrate **36**. (See step **S130**). In the preferred embodiment, the support substrate is formed of a dielectric material, such as a Pyrex glass, such that the support substrate also electrically insulates the MEMS device.

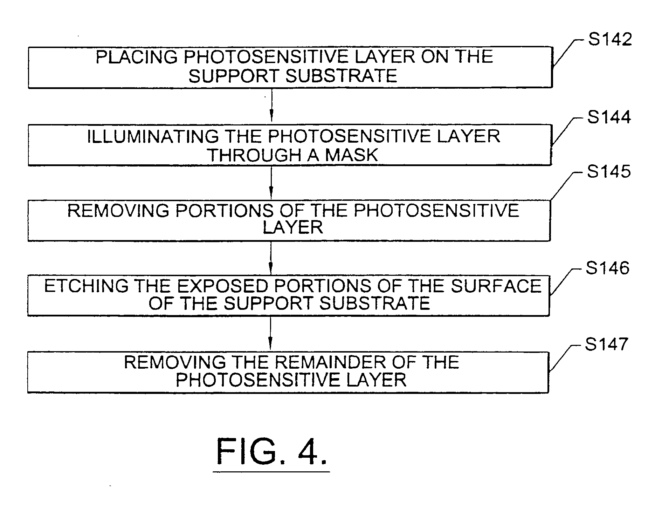

Also, with reference to Figures 2A and 3, the method of the present invention includes the step of etching sections of the support substrate such that mesas 38 are formed that extend outwardly from the inner surface **36a** of the support substrate 36. (See step **S140**). With reference to Figures 2A and 4, the mesas are formed by first placing a photosensitive layer or film (not shown) on the inner surface of the support substrate. As known to those skilled in the art, the photosensitive film is commonly referred to as photoresist. (See step **S142**). Thereafter, the photosensitive film is at least partially covered by a mask and the exposed portions of the photoresistive film illuminated. (See step **S144**). In this regard, although the photosensitive film is typically illuminated with a UV light source, the photosensitive film can be illuminated with any particular light source capable of exposing the photosensitive film.

After portions of the photosensitive material have been exposed to light, portions of the photosensitive film are removed by exposing the photosensitive film to a developer solution, such as Shipley developer concentrate. (See step **S145**). As known to those skilled in the art, either the portions of the photosensitive film that were exposed to the light or the portions of the photosensitive film that were not exposed to the light will be removed depending upon whether a positive or a negative photosensitive film is utilized, respectively. The portions of the support substrate that are not covered by the remaining photosensitive film are then etched, such as with reactive ion etching (RIE). (See step **S146**). The etching process continues until the portions of the support substrate surrounding the mesas **38** have been removed such that the mesas have the desired height. Thereafter, the remaining portions of the photosensitive layer are removed. (See step **S147**).

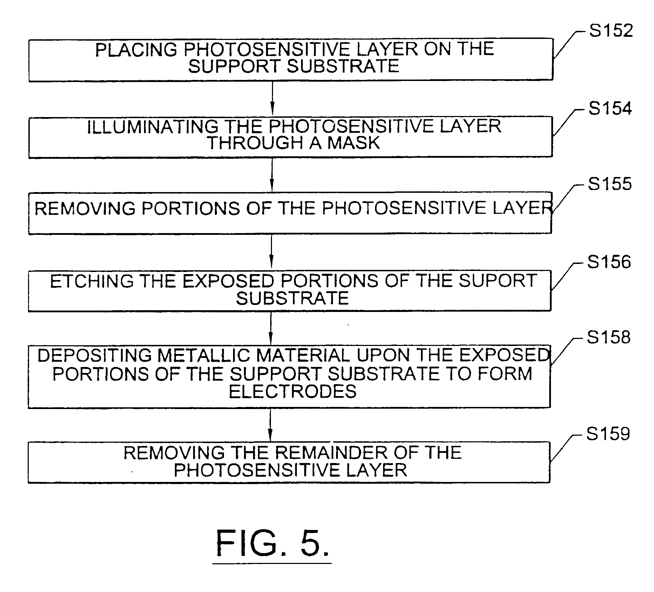

With reference to Figures 2B, 2C, and 3, after the mesas **38** have been formed on the support substrate, the method of the present invention further includes the step of depositing a metallic material on the inner surface 36a of the support substrate **36** and, more particularly, on the mesas **38** to form electrodes **42**. (See step **S150**). To prevent the metal deposited upon the mesas from extending too far above the surface of the mesas, however, the mesas are first selectively etched to define recessed regions in which the metal may be deposited. With reference to Figures 2B, 2C, and 5, the step of forming electrodes on the mesa **38** includes the step of placing photosensitive material (not shown) on the inner surface **36a** of the support substrate **36** and patterning the photosensitive material such that the photosensitive material only covers those regions of the inner surface **36a** upon which metal is not to be deposited. In other words, those portions of the inner surface of the support substrate that are to be etched and thereafter coated with a metal are not covered by the patterned photosensitive material and are therefore exposed. (See steps **S152**, **S154** and **S155**). The method of the present invention further includes the step of etching the exposed portions of the inner surface of the support substrate, such as by means of BOE, to form recessed regions **46** in the predefined pattern. (See step **S156**).

With reference to Figures 2C and 5, the method of the present invention further includes the step of depositing metallic material in the etched recesses **46** to form electrodes **42** and conductive traces (not shown). (See step **S158**). As known in the art, the electrodes and traces may be comprised of any conductive material, such as a multilayered deposition of titanium, platinum, and gold and may be deposited by any suitable technique, such as sputtering. Thereafter, the remaining portions of the photosensitive layer are removed. (See step **S159**).

With reference to Figures 2C and 3, the inner surface of the partially sacrificial substrate is also etched to separate or otherwise form the mechanical and/or electromechanical members of the resulting MEMS device. (See step **S160**). As stated previously, the procedure for forming the mechanical and/or electromechanical members requires tight tolerances such that members having precise dimensions can be reliably formed. In particular, since the mesas are formed on the support substrate instead of the inner surface of the partially sacrificial substrate, at least those portions of the inner surface of the partially sacrificial substrate that will be subsequently etched to form the mechanical and/or electromechanical members are planar so as to facilitate the precise formation of the mechanical and/or electromechanical members.

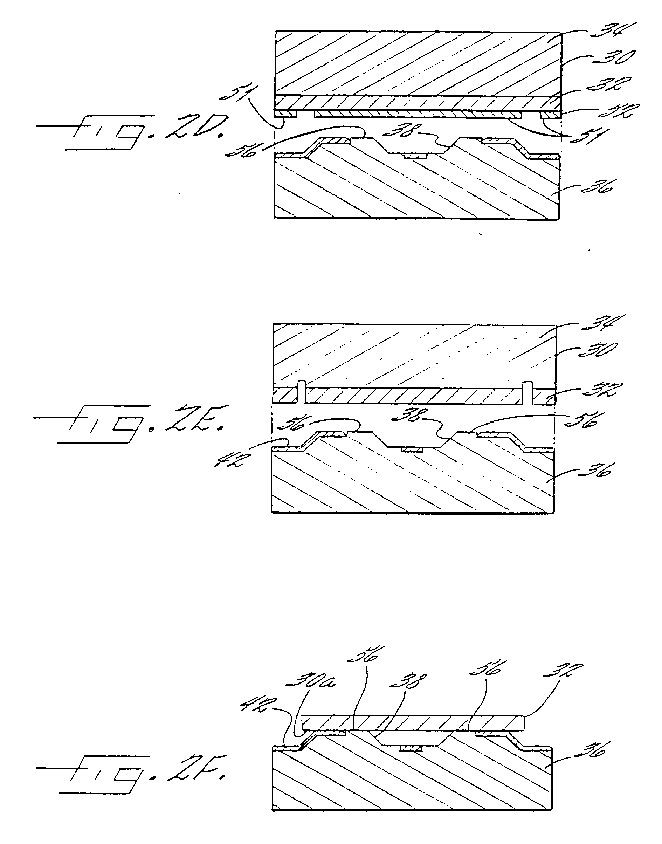

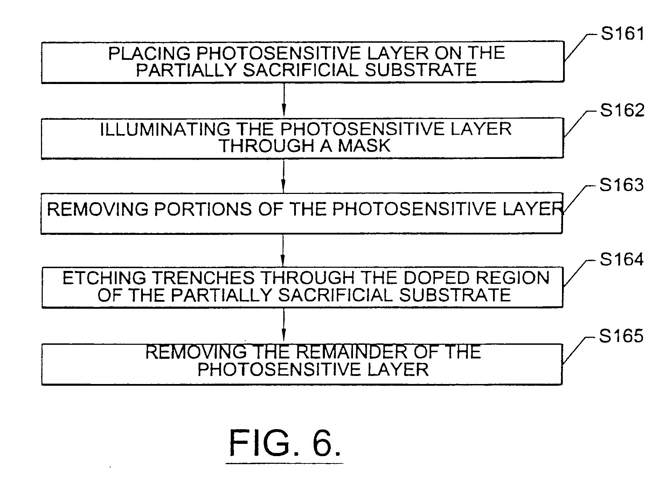

In detail, with reference to Figures 2C, 2D and 6, the mechanical and/or electromechanical members are formed by initially coating the inner surface of the partially sacrificial substrate with a photosensitive layer **48**. (See step **S161**). After covering the photosensitive layer with a mask that defines the regions to eventually be etched, the exposed portions of the photosensitive layer are illuminated. (See step **S162**). After removing the mask, portions of the photosensitive layer **50** are removed such that the remaining portion **51** of the photosensitive layer does not cover those regions of the inner surface of the partially sacrificial substrate which will eventually be etched. (See step **S163**).

With reference to Figure 2E, the exposed portions of the inner surface of the partially sacrificial substrate are then etched, such as by RIE etching, to form trenches through the doped region of the partially sacrificial substrate. (See step **S164**). As described below, the doped region of the partially sacrificial substrate that extends between the trenches will form the resulting mechanical and/or electromechanical member(s) of the MEMS device. After the mechanical and/or electromechanical members of the MEMS device have been defined by the etched trenches, the method of the present invention removes the remaining photosensitive material **51** from the inner surface of the partially sacrificial substrate. (See step **165**).

With reference to Figures 2F and 3, the method of the present invention also includes the step of placing the inner surface of the partially sacrificial substrate in contact with the mesas, including the electrodes deposited on the surface of the mesas. (See step **S170**). A bond is then formed between the partially sacrificial substrate and the mesas. (See step **S180**). In a preferred embodiment, the bond is an anodic bond, however, it is understood that the bond could be of any type that provides for a secure engagement.

It is also oftentimes advantageous to remove the undoped sacrificial region of the partially sacrificial substrate such that the mechanical and/or electromechanical members can rotate, move, and flex. This technique is commonly referred to as a dissolved wafer process (DWP). Thus, in one embodiment, the method of the present invention further includes the step of removing the undoped sacrificial region of the partially sacrificial substrate. (See step **S190**). The removal of the undoped sacrificial region is typically performed by etching away the undoped sacrificial region such as with an ethylenediamine pyrocatechol (EDP) etching process, however, any doping-selective etching procedure may be used.

As stated above, the removal of the undoped sacrificial region of the partially sacrificial substrate provides several advantages. For instance, the removal of this material allows the mechanical and/or electromechanical members etched from the doped region to have freedom of movement so as to move or flex in relation to the support substrate. In addition, the removal of the undoped sacrificial region of the partially sacrificial substrate also disconnects the mechanical and/or electromechanical members from the remainder of the doped region of the partially sacrificial substrate outside of the trenches etched through the doped region.

With reference to Figure 2A, it is oftentimes advantageous to provide mesas **38** that have a contact surface **56** that extends between a set of sloped sidewalls **58**. These sloped sidewalls **58** allow the metal to be deposited on both the contact surface and at least one sidewall of the mesa by "stepping" metal up the sidewall to the contact surface.

It is important to note that the mesas may assume any geometric form. For instance, in this embodiment, the mesas are formed in a frusto pyramidal shape, however, the cross-sectional shape of the mesas may also assume other forms such as octagonal, cylindrical, etc. as needed for the particular application. Further, it is understood that although the sloped sidewalls are referred to as a set of sloped sidewalls, only one of the sidewalls of the set may be sloped in some applications.

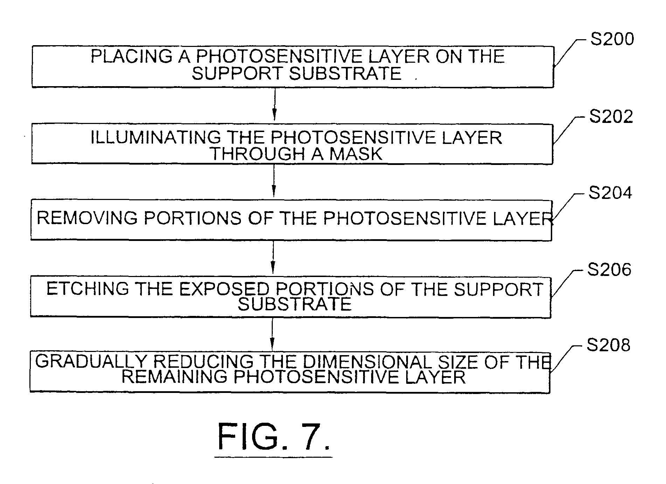

With reference to Figure 7 which illustrates the operations required to create mesas with sloped sidewalls, the method of this embodiment of the present invention includes the step of applying a photosensitive layer to the inner surface of the support substrate that is patterned to only cover those locations that correspond to the eventual locations of the mesas. (See steps **S200**, **S202** and **S204**). Thus, the photosensitive layer is formed of a number of pads, each of which will define a respective mesa. Each pad is dimensionally sized to approximate the dimensions of the base of the respective mesa. The method of the present invention further includes the step of etching the exposed inner surface of the support substrate. (See step **S206**). As the etching step is performed, the etchant also etches the photosensitive layer, thereby gradually reducing the dimensional size of various parts of the photoresist. (See step **S208**). As shown in Figure 2A, this gradual reduction in the size of the pads creates mesas **38**, each of which has a set of sloped sidewalls **58** and a contact surface **40** extending therebetween. As shown, the contact surface **40** has a smaller dimensional size than the base **54** of the mesa.

In addition to a method for making MEMS devices, the present invention is also directed to the resulting MEMS device, as shown in Figure 2F for example. As described above in conjunction with the method, the resulting MEMS device of the present invention includes a semiconductive substrate **30** that includes a first inner surface **30a**. As discussed earlier, the semiconductive substrate can be formed of silicon, gallium arsenide, germanium or the like that has a doped region **32** adjacent to the first inner surface **30a**. The doped region of the semiconductive substrate forms the mechanical members of the MEMS device. Further, the doped region is typically doped with boron, however, the region may be doped with other dopants such as indium, thallium, and aluminum.

The MEMS device of this embodiment of the present invention further includes a support substrate **36**. The support substrate serves to suspend the semiconductive substrate, such that the mechanical and/or electromechanical parts defined by the semiconductive substrate have increased freedom of movement or flex. However, the support substrate can also perform other functions, such as by serving as an electrical insulator or a heat sink for the mechanical and/or electromechanical parts of the MEMS device. As such, the support substrate is typically formed of a dielectric material, such as Pyrex glass.

The MEMS device of the present invention and, more particularly, the support substrate further includes at least one mesa **38**. This mesa extends outwardly from the remainder of the support substrate **36** and serves to support the semiconductive substrate **36**. As discussed previously, because the mesas **38** are formed on the support substrate as opposed to the semiconductive substrate, the inner surface of the semiconductive substrate remains highly planar to facilitate precise and controlled etching of the trenches through the doped region of the semiconductive substrate. As described above, the mesa includes a contact surface **56** that supports the inner surface **30a** of the semiconductive substrate such that the semiconductive substrate is suspended over the remainder of the support substrate **38**.

In one embodiment of the MEMS device of the present invention, electrodes **42** are formed on the mesa **38** to provide an electrical connection to the mechanical and/or electromechanical members of the MEMS device. In an embodiment of the present invention, the mesa includes a contact surface **56** that extends between a set of sloped sidewalls **58**. In this embodiment, the electrodes are deposited on both the contact surface **56** and at least one of the sloped sidewalls **58** of the mesa. The resulting electrodes are therefore exposed on the sidewalls of the respective mesas to facilitate electrical contact therewith.

As described above, the contact surface **56** of the mesa supports the inner surface **30a** of the semiconductive substrate. In some embodiments, the contact surface of the mesas and the inner surface of the semiconductive substrate are bonded or otherwise joined. For example, the contact surfaces of the mesas and the inner surface of the semiconductive substrate can be bonded by an anodic bond or the like.

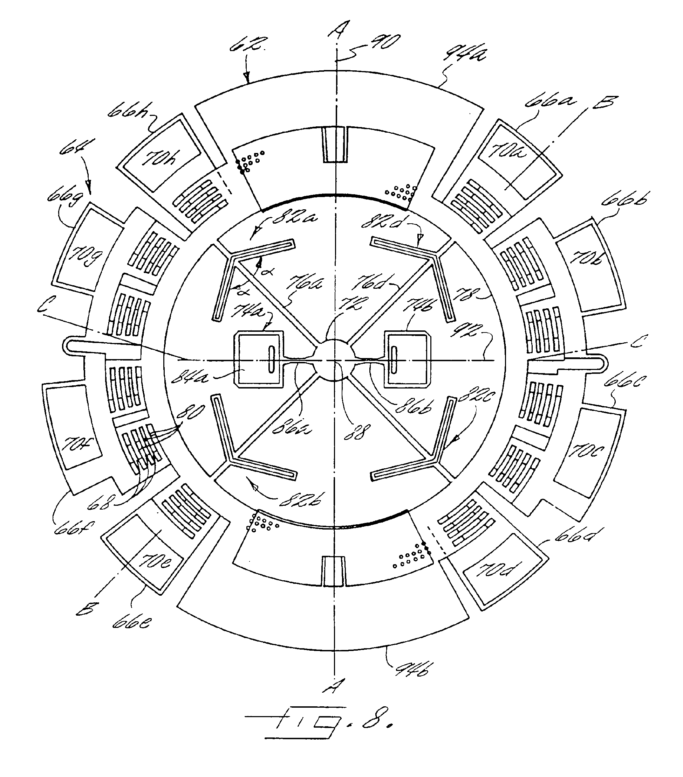

As discussed previously, MEMS devices are used in a wide variety of applications. One application in particular is a gimballed vibrating wheel gyroscope such as described in U.S. Patent No. 5,650,568 to Greiff et al. As described in the Greiff et al. patent, and illustrated in Figure 8, the gyroscope includes a plurality of mechanical and/or electromechanical members that are etched from a semiconductive substrate. These members generally include a wheel assembly, or rotor **62**, a stator **64**, and a plurality of drive electrodes **66a-h** that terminate at a plurality of finger-like members **68**. According to the present invention and unlike the Greiff et al. patent, these members are supported over a support substrate (not shown), by a plurality of mesas **70a-h** that extend outward from the support substrate.

As shown in Figure 8, the rotor **62** includes a central hub **72,** suspended over the support substrate by a pair of post assemblies **74a** and **74b,** a plurality of spokes **76a-d** and an outer wheel or rim **78** from which a plurality of finger-like members **80** extend. The finger-like members **80** of the rotor are interleaved with the finger-like members **68** of the stator **64** for electrostatic actuation by the stator **64**. Each of the spokes **74a-b** includes a respective box-shaped strain relief portion **82a-d**.

Each of the post assemblies **74a** and **74b** includes a respective support post **84a** and **84b** and post flexure **86a** and **86b,** referred to alternatively as output flexures **86a** and **86b**. A drive circuit (not shown) is also coupled to the stator drive electrodes **66a-h**.

Upon energization of the drive electrodes **66a-h**, the rim **78** of the wheel assembly **62** vibrates, or oscillates rotationally in the plane of the assembly about a drive axis **88**. The gyroscope may be operated in a self-oscillatory manner or, alternatively, may be operated open loop. When the wheel rim **78** is vibrating rotationally, variations in the rotational rate of the vehicle upon which the gyroscope is mounted relative to an input axis **90** will cause the rim of the wheel assembly to deflect out of the plane of the gyroscope about the output axis **92**.

A plurality of sense regions **94a**, **94b** extend from the rim **78** of the wheel assembly **62** along the input axis **90**. Sense electrodes **94a**, **94b** are disposed on the support substrate and below respective sense regions **94a**, **94b** for sensing the out-of-plane deflection of the assembly **62**.

As described in the Greiff patent, these gyroscopes are typically constructed using a dissolved wafer process (DWP) as discussed below. However, it must be understood that any microelectromechanical manufacturing process may be used to manufacture the improved gyroscope of the present invention.

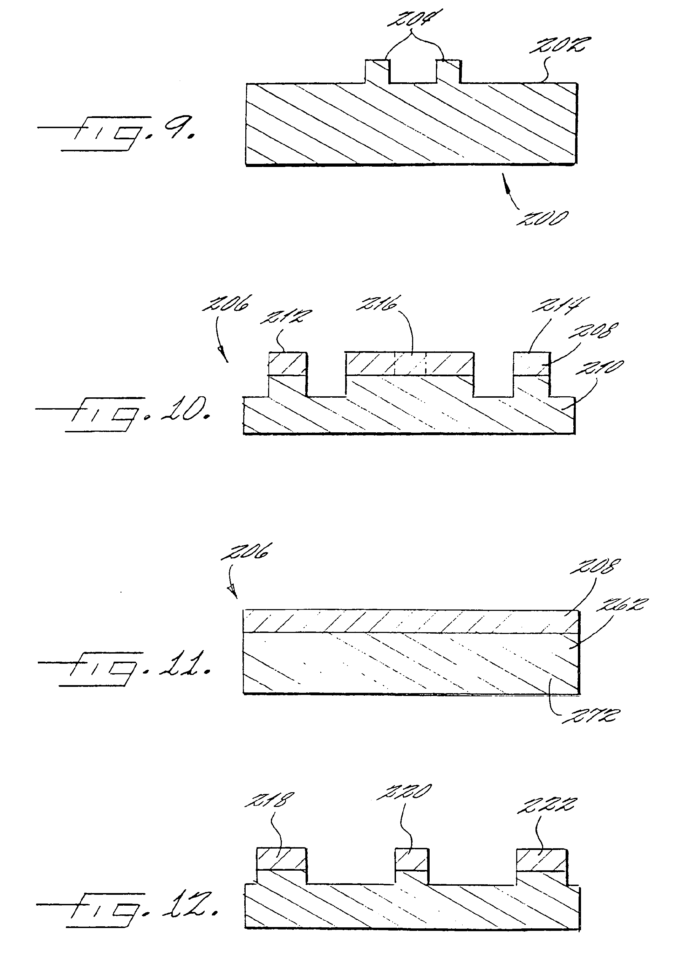

Referring initially to Figure 9, a support substrate **200** is provided having a thickness of approximately 750 microns. In one embodiment, the support substrate **200** is comprised of glass, such as PYREX glass. The support substrate has an inner or top surface **202**, which is patterned and etched according to a conventional photolithographic process, as described above, to provide mesas **204** which support other portions of the gyroscope.

Referring now to Figure 10, a semiconductive substrate **206** having a thickness on the order of 500 microns is initially doped to a predetermined depth, such as to approximately ten microns, to provide a doped region **208** and an undoped sacrificial region **210**. In the illustrative embodiment, region **208** is doped with boron. This boron doped region **208** will eventually form the wheel assembly **62** of the gyroscope.

Referring to Figure 11, the semiconductive substrate is thereafter patterned and etched, such as by RIE etching, to define the wheel assembly **62** in accordance with requirements of the particular application. In the illustrative embodiment, the etching of the semiconductive substrate Figure 10 forms regions **212** and **214** which provide portions of the outer rim **78** along axis C (see Figure 8) and further separates a central portion from the spaced regions **212** and **214**, as shown. The portion **216** of doped region **208** between regions **212** and **214** forms the central hub **72** (See Figure 8) and the output flexures **86a** and **86b** of the gyroscope.

Referring now to Figures 11 and 12, a cross-section of the gyroscope taken along input axis A (Figure 8) is shown following the above-described fabrication steps. More specifically, in Figure 11, the semiconductive substrate **206** is shown to also have a boron doped region **208.** Note that this cross-section of gyroscope along axis A does not cut through any regions similar to regions **212** and **214** of Figure 10.

The RIE etching by which the structure of Figure 10 is formed further forms three regions **218**, **220**, and **222** along axis A, as shown in Figure 12. Central region **220** forms the central hub **72**, see Figure 8, and spaced regions **218** and **222** form portions of the outer rim **78** of the wheel assembly **62**.

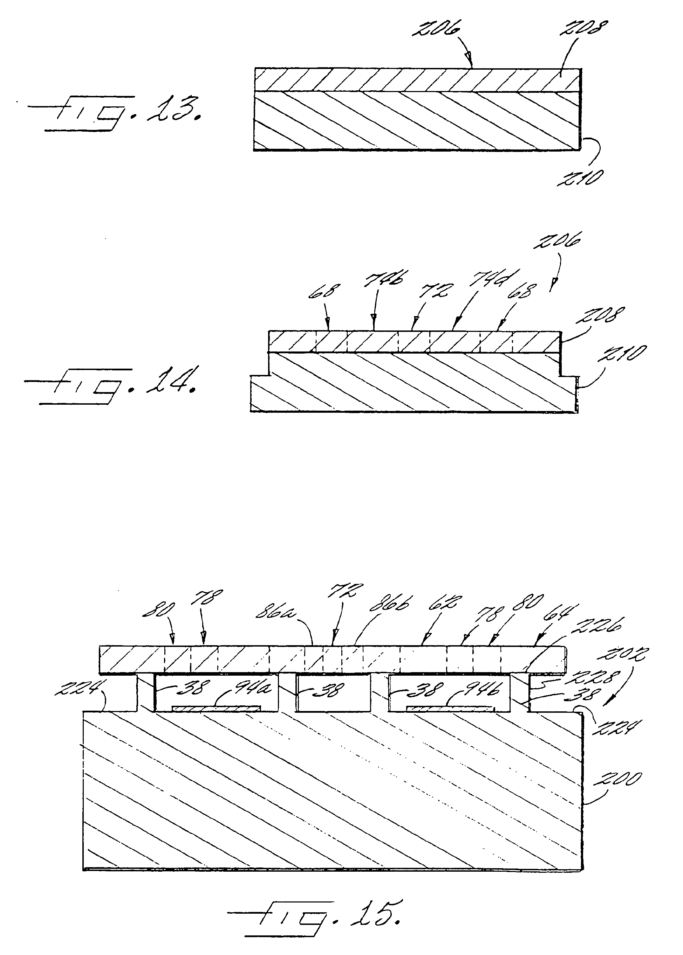

Referring also to Figure 13, a cross-section of the gyroscope along axis B (Figure 8) is shown. The RIE etching by which the structure shown in Figures 10 and 12 is formed yields the structure of Figure 13 along axis B. More particularly, the etching step cuts through the boron doped region **206**, as shown. The remaining portions of the boron doped region **206** form spoke flexures **74b** and **74d**, central hub **72**, and interleaved finger-like members **80** of the wheel assembly **62**, as well as the finger-like members **68** of the stator **64**.

Referring to Figure 15, a cross-sectional view of the complete gyroscope of Figure 8 is shown taken along axis C. The sense electrodes **94a** and **94b** are formed over the top surface **202** of the support substrate **200**. The sense electrodes **94a** and **94b** may be comprised of any suitable conductive material, such as a multilayered deposition of titanium, platinum, and gold, and may be deposited by any suitable technique, such as sputtering. Conductive traces **224** are also provided on a top surface **202** of the support substrate **200** so as to extend from a contact surface **226** on the mesas, down at least one sidewall **228** of the mesas to the edge portions of the support substrate **202**. Further, traces **224** provide electrical connection to the drive electrodes **66a-h** (not shown) for applying a drive signal to the drive electrodes.

Once the support substrate **200** is processed to form sense electrodes **94a** and **94b** and conductive traces **224**, the wheel assembly structure as shown along different axes in the cross-sections of Figures 1014 is bonded to the contact surface **226** of the mesas of the support substrate **200**. More particularly, the semiconductive substrate is inverted and bonded to the support substrate **200** by anodic bonding. Although not shown, it will be appreciated that any undoped region **210** of the semiconductive substrate may be removed, such as by DWP. The wheel assembly **62** and stator **64** are thus suspended over the support substrate **200**, as shown in Figure 17, by means of the mesas extending outwardly from the top surface of the support substrate. Features of the wheel assembly **62** shown in the view of Figure 17 include the central hub **72**, output flexures **86a** and **86b**, outer rim **78**, and rotor finger-like electrodes **80**.

As discussed earlier, and shown in Figures 9 and 17, the gyroscope of the present invention includes mesas that are formed on the support substrate **200** as opposed to the semiconductive substrate **206**. Because the mesas are etched from the support substrate, the inner surface of the semiconductive substrate remains planar prior to forming the trenches which define the mechanical and/or electromechanical members of the resulting gyroscope.

## Claims

1. A method for forming a micro-electromechanical structure, wherein said method comprises the steps of:
providing a partially sacrificial substrate (30) having a first surface (30a);
doping a portion of said partially sacrificial substrate with a dopant such that said partially sacrificial substrate includes a doped region (32) and an undoped region (34), wherein the doped region is adjacent the first surface of said partially sacrificial substrate;
providing a support substrate (36) for supporting said partially sacrificial substrate, wherein said support substrate is a dielectric material;
forming at least one mesa (38) on a respective surface (36a) of said support substrate such that said at least one mesa extends outwardly from the respective surface and has a contact surface (56) extending between a set of sloped side walls (58);
depositing a conductive material on at least a portion of the contact surface and at least one of the sloped sidewalls of said at least one mesa to form an electrode (42); and
bonding said first surface (30a) of said partially sacrificial substrate to said at least one mesa (38) such that the first surface (30a) of said partially sacrificial substrate (30) is suspended above the remainder of the respective surface (36a) of said support substrate with the doped region (32) of said partially sacrificial substrate in a facing relationship thereto.

2. A method according to Claim 1, further comprising the step of removing said undoped region (34) of said partially sacrificial substrate following said bonding step.

3. A method according to Claim 1, wherein the electrode (42) is disposed in electrical communication with the doped region (32) of said partially sacrificial substrate (30) following said bonding step.

4. A method according to Claim 1, wherein said forming step comprises the steps of:
applying a photoresistive layer to said surface (36a) of said support substrate (36) at a location corresponding to a predetermined location of said mesa (38), wherein said photoresistive layer is dimensionally sized to approximate the dimensions of a base of the mesa;
etching the exposed surface of said support substrate (36);
gradually reducing the dimensional size of the photoresistive layer during said etching step such that the resulting mesa comprises the contact surface (56) extending between the set of sloped sidewalls (58) and having dimensions smaller than the base of the mesa.

5. A method according to Claim 1, further comprising:
dissolving said undoped region (34) from said partially sacrificial substrate (30) such that said members of the resulting micro-electromechanical device defined by said doped region (32) of said partially sacrificial substrate are moveable in relation to said support substrate.

6. A method according to Claim 1, wherein said bonding step comprises the step of anodically bonding said first surface (30a) of said partially sacrificial substrate (30) to said mesa (38) of said support substrate (36).

7. A micro-electromechanical device comprising:
a doped region of a partially sacrificial substrate (32) defining at least one member of the micro-electromechanical device; and
a support substrate (36) for supporting said doped region, wherein said support substrate is a dielectric material and includes at least one mesa (38) extending outwardly from a respective surface of a support substrate, wherein said mesa includes a contact surface (56) that supports said doped region (32);
such that said doped region is suspended above a remainder of the respective surface of said support substrate, wherein said contact surface of said mesa extends between a set of sloped sidewalls (58); **characterized by**
an electrode (42), in electrical communication with said doped region, extending across a portion of said contact surface and at least one of said sloped sidewalls of said mesa.

## Patentansprüche

1. Verfahren zum Ausbilden einer mikroelektromechanischen Struktur, wobei das Verfahren die folgenden Schritte umfasst:
Bereitstellen eines teilweise opfernden Substrats (30) mit einer ersten Oberfläche (30a);
Dotieren eines Abschnitts des teilweise opfernden Substrats mit einem Dotierstoff, so dass das teilweise opfernde Substrat ein dotiertes Gebiet (32) und ein undotiertes Gebiet (34) enthält, wobei sich das dotierte Gebiet neben der ersten Oberfläche des teilweise opfernden Substrats befindet;
Bereitstellen eines Trägersubstrats (36) zum Tragen des teilweise opfernden Substrats, wobei das Trägersubstrat ein dielektrisches Material ist;
Ausbilden mindestens einer Mesa (38) auf einer jeweiligen Oberfläche (36a) des Trägersubstrats, so dass sich die mindestens eine Mesa von der jeweiligen Oberfläche nach außen erstreckt und eine Kontaktoberfläche (56) aufweist, die sich zwischen einem Satz von schrägen Seitenwänden (58) erstreckt;
Abscheiden eines leitenden Materials auf mindestens einem Abschnitt der Kontaktoberfläche und mindestens einer der schrägen Seitenwände der mindestens einen Mesa, um eine Elektrode (42) auszubilden; und
Bonden der ersten Oberfläche (30a) des teilweise opfernden Substrats an die mindestens eine Mesa (38), so dass die erste Oberfläche (30a) des teilweise opfernden Substrats (30) über dem Rest der jeweiligen Oberfläche (36a) des Trägersubstrats suspendiert ist, wobei das dotierte Gebiet (32) des teilweise opfernden Substrats sich in einer gegenüberliegenden Beziehung dazu befindet.

2. Verfahren nach Anspruch 1, weiterhin umfassend den Schritt des Entfernens des undotierten Gebiets (34) des teilweise opfernden Substrats nach dem Bondingschritt.

3. Verfahren nach Anspruch 1, wobei die Elektrode (42) in elektrischer Kommunikation mit dem dotierten Gebiet (32) des teilweise opfernden Substrats (30) nach dem Bondingschritt angeordnet wird.

4. Verfahren nach Anspruch 1, wobei der Ausformungsschritt die folgenden Schritte umfasst:
Aufbringen einer lichtempfindlichen Schicht auf der Oberfläche (36a) des Trägersubstrats (36) an einem Ort entsprechend einem vorbestimmten Ort der Mesa (38), wobei die lichtempfindliche Schicht dimensionsmäßig so bemessen ist, dass sie den Abmessungen einer Basis der Mesa nahekommt;
Ätzen der exponierten Oberfläche des Trägersubstrats (36);
allmähliches Reduzieren der Abmessungsgröße der lichtempfindlichen Schicht während des Ätzschritts, so dass die resultierende Mesa die Kontaktoberfläche (56) umfasst, die sich zwischen dem Satz von schrägen Seitenwänden (58) erstreckt und Abmessungen aufweist, die kleiner sind als die Basis der Mesa.

5. Verfahren nach Anspruch 1, weiterhin umfassend:
Lösen des undotierten Gebiets (34) von dem teilweise opfernden Substrat (30), so dass die Elemente der resultierenden mikroelektromechanischen Einrichtung, definiert durch das dotierte Gebiet (32) des teilweise opfernden Substrats, in Relation zu dem Trägersubstrat bewegt werden können.

6. Verfahren nach Anspruch 1, wobei der Bondingschritt den Schritt des anodischen Bondens der ersten Oberfläche (30a) des teilweise opfernden Substrats (30) an die Mesa (38) des Trägersubstrats (36) umfasst.

7. Mikroelektromechanische Einrichtung, umfassend:
ein dotiertes Gebiet eines teilweise opfernden Substrats (32), mindestens ein Element der mikroelektromechanischen Einrichtung definierend; und
ein Trägersubstrat (36) zum Tragen des dotierten Gebiets, wobei das Trägersubstrat ein dielektrisches Material ist und mindestens eine Mesa (38) enthält, die sich von einer jeweiligen Oberfläche eines Trägersubstrats nach außen erstreckt, wobei die Mesa eine Kontaktoberfläche (56) enthält, die das dotierte Gebiet (32) trägt;
so dass das dotierte Gebiet über einem Rest der jeweiligen Oberfläche des Trägersubstrats suspendiert ist, wobei die Kontaktoberfläche der Mesa sich zwischen einem Satz von schrägen Seitenwänden (58) erstreckt, **gekennzeichnet durch**
eine Elektrode (42) in elektrischer Kommunikation mit dem dotierten Gebiet, die sich über einen Abschnitt der Kontaktoberfläche und mindestens eine der schrägen Seitenwände der Mesa erstreckt.

## Revendications

1. Procédé de formation d'une microstructure électromécanique, ledit procédé comprenant les étapes qui consistent à :
prévoir un substrat (30) partiellement sacrifiable et doté d'une première surface (30a),
doper une partie dudit substrat partiellement sacrifiable avec un dopant de telle sorte que ledit substrat partiellement sacrifiable comprenne une partie dopée (32) et une partie non dopée (34), la partie dopée étant adjacente à la première surface dudit substrat partiellement sacrifiable,
prévoir un substrat de support (36) qui supporte ledit substrat partiellement sacrifiable, ledit substrat de support étant un matériau diélectrique,
former au moins une mésa (38) sur une surface respective (36a) dudit substrat de support de telle sorte que ladite ou lesdites mésas s'étendent vers l'extérieur depuis la surface respective présente une surface de contact (56) qui s'étend entre un jeu de parois latérales (58) en pente,
déposer un matériau conducteur sur au moins une partie de la surface de contact et au moins une des parois latérales en pente de ladite ou desdites mésas pour former une électrode (42) et
relier ladite première surface (30a) dudit substrat partiellement sacrifiable à ladite ou auxdites mésas (38) de telle sorte que la première surface (30a) dudit substrat (30) partiellement sacrifiable soit suspendue au-dessus du reste de la surface respective (36a) dudit substrat de support, la partie dopée (32) dudit substrat partiellement sacrifiable lui faisant face.

2. Procédé selon la revendication 1, comprenant en outre l'étape qui consiste à retirer ladite région non dopée (34) dudit substrat partiellement sacrifiable après ladite étape de liaison.

3. Procédé selon la revendication 1, dans lequel l'électrode (42) est placée en communication électrique avec la partie dopée (32) dudit substrat partiellement sacrifiable (30) après ladite étape de liaison.

4. Procédé selon la revendication 1, dans lequel ladite étape de façonnage comprend les étapes qui consistent à :
appliquer une couche de photorésist sur ladite surface (36a) dudit substrat de support (36) en un emplacement qui correspond à un emplacement prédéterminé de ladite mésa (38), ladite couche de photorésist étant dimensionnée de manière à approcher les dimensions de la base de la mésa,
graver la surface exposée dudit substrat de support (36),
réduire progressivement la taille de la couche de photorésist pendant ladite étape de gravure, de telle sorte que la mésa ainsi obtenue comprenne la surface de contact (56) qui s'étend entre le jeu de parois latérales (58) en pente et dont les dimensions sont inférieures à celles de la base de la mésa.

5. Procédé selon la revendication 1, comprenant en outre l'étape qui consiste à dissoudre ladite partie non dopée (34) dudit substrat partiellement sacrifiable (30) de telle sorte que lesdits éléments du micro-dispositif électromécanique ainsi obtenu et défini par ladite partie dopée (32) dudit substrat partiellement sacrifiable puissent se déplacer par rapport audit substrat de support.

6. Procédé selon la revendication 1, dans lequel ladite étape de liaison comprend l'étape qui consiste à lier anodiquement ladite première surface (30a) dudit substrat partiellement sacrifiable (30) à ladite mésa (38) dudit substrat de support (36).

7. Micro-dispositif électromécanique comprenant :
une partie dopée dans un substrat partiellement sacrifiable (32) qui définit au moins un élément du micro-dispositif électromécanique et
un substrat de support (36) qui porte ladite partie dopée, ledit substrat de support étant en matériau diélectrique et comprenant au moins une mésa (38) qui s'étend vers l'extérieur depuis une surface respective d'un substrat de support, ladite mésa comprenant une surface de contact (56) qui porte ladite partie dopée (32),
de telle sorte que ladite partie dopée soit suspendue au-dessus du reste de la surface respective dudit substrat de support, ladite surface de contact de ladite mésa s'étendant entre un ensemble de parois latérales (58) en pente,
**caractérisé par**
une électrode (42) en communication électrique avec ladite partie dopée et s'étendant sur une partie de ladite surface de contact et au moins l'une desdites parois latérales en pente de ladite mésa.
